(19) Europäisches Patentamt / European Patent Office / Office européen des brevets

(11) **EP 3 608 644 B1**

(12) **EUROPÄISCHE PATENTSCHRIFT**

(45) Veröffentlichungstag und Bekanntmachung des Hinweises auf die Patenterteilung:
**24.03.2021 Patentblatt 2021/12**

(51) Int Cl.:
*G01K 7/01* (2006.01)     *H03K 17/082* (2006.01)
*H03K 17/08* (2006.01)     *H03K 17/00* (2006.01)

(21) Anmeldenummer: **18188227.5**

(22) Anmeldetag: **09.08.2018**

(54) **VERFAHREN ZUM BESTIMMEN EINES VORZEICHENS EINES LASTSTROMS IN EINER BRÜCKENSCHALTUNG MIT MINDESTENES EINER LEISTUNGSHALBLEITERSCHALTUNG**

METHOD OF DETERMINING A SIGN OF A LOAD CURRENT IN A BRIDGE CIRCUIT WITH AT LEAST ONE POWER SEMICONDUCTOR CIRCUIT

PROCÉDÉ DE DÉTERMINATION D'UN SIGNE D'UN COURANT DE CHARGE DANS UN CIRCUIT EN PONT AVEC AU MOINS UN COMMUTATEUR DE SEMI-CONDUCTEURS DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**12.02.2020 Patentblatt 2020/07**

(73) Patentinhaber: **Infineon Technologies AG**
**85579 Neubiberg (DE)**

(72) Erfinder:
• **Arens, Andre**
**59602 Ruethen (DE)**
• **Jakobi, Waldemar**
**59494 Soest (DE)**

(74) Vertreter: **Dilg, Haeusler, Schindelmann Patentanwaltsgesellschaft mbH**
**Leonrodstraße 58**
**80636 München (DE)**

(56) Entgegenhaltungen:
EP-A1- 1 830 405     EP-A2- 2 444 817
GB-A- 2 549 934     JP-A- 2001 085 629
US-A1- 2012 175 780     US-B2- 6 995 555

**Beschreibung**

Die vorliegende Erfindung betrifft ein Verfahren zum Bestimmen eines Vorzeichens eines Laststroms in einer Brückenschaltung mit mindestens einer Leistungshalbleiterschaltung zur Bestimmung einer Temperatur und gegebenenfalls eines Stroms, aufweisend ein Leistungshalbleiterelement und einen Temperatursensor, wobei das Leistungshalbleiterelement eine Gateelektrode zum Ansteuern des Leistungshalbleiterelements, eine Kollektorelektrode und eine Emitterelekrode aufweist, wobei die Emitterelektrode mit einem ersten Emitteranschluss elektrisch verbunden ist und der Temperatursensor einen ersten Messpunkt mit einem Messanschluss und einen zweiten Messpunkt aufweist.

Stand der Technik

Bipolartransitoren mit isolierter Gate-Elektrode (IGBT) sind Halbleiterbauelemente welche Anwendung in der Leistungselektronik finden (hierin auch als Leistungshalbleiterbauelemente bezeichnet). Solche Halbleiterbauelemente sind hohen Temperaturen und hohen Stromflüssen ausgesetzt, welche gegebenenfalls zu Beschädigungen bis hin zur Zerstörung der Halbleiterbauelemente führen.
Um die Halbleiterbauelemente gegen hohe Temperaturen zu schützen, werden Temperatursensoren verwendet. Hierbei wird oftmals ein separater Temperatursensor in Form eines separaten Chips verwendet, welcher auf das Gehäuse oder den Kühlkörper des Halbleiterbauelements aufgebracht ist. Hierbei ist nachteilig, dass die Temperatur nicht im Inneren des Halbleiterbauelements gemessen wird, wo die Temperatur am höchsten ist. Das heißt es wird hier nicht die Temperatur des Halbleiterbauelements direkt gemessen, sondern lediglich die Temperatur des mit diesem in Verbindung stehenden Gehäuses oder einer Leiterplatte bzw. Bodenplatte.
Daher finden auch Temperatursensoren Einsatz, welche innerhalb eines Moduls neben dem Chip eines IGBT angeordnet sind. Hierbei ist der Temperatursensor galvanisch von der Elektronik des IGBT getrennt. Nachteilig bei einer solchen Anordnung ist der erhöhte Platzbedarf und damit gegebenenfalls eine reduzierte Fläche, welche für das eigentliche Halbleiterbauelement zur Verfügung steht.
Bekannt sind auch IGBTs mit integrierter Überstrommessung zur Bestimmung eines Überstroms. Temperature-Current-Sense (TCS) IGBTs legen üblicherweise 1/2000 bis 1/1000 der IGBT Zellen auf einen separaten Anschluss, welcher für normalleitende n-Kanal-Transistoren die Emitterelektrode ist. Ein Messwiderstand zwischen der Emitterelekrode und einem Hilfsemitteranschluss erzeugt im Leitzustand des IGBT einen Spannungsfall, welcher gemessen und zur Bestimmung eines Überstroms ausgewertet wird. Nachteilig bei dieser Anordnung ist, dass ein Teil der Zellen des IGBT zur Strommessung verwendet werden und somit nicht für die eigentliche Aufgabe des IGBT zur Verfügung stehen. Ferner wird für den Anschluss zusätzlicher Platz in dem Modul benötigt. Der Messwiderstand befindet sich üblicherweise auf einer übergeordneten Leiterplatte bzw. Platine.
Ein TCS-IGBT nach dem Stand der Technik weist somit zwei Messzweige auf, einen ersten für die Temperaturmessung und einen zweiten für die Strommessung. Dies resultiert ebenfalls in einem erhöhten Platzbedarf des TCS-IGBT und einer erhöhten Anzahl von Anschlüssen.
US 2012 0175780 A1 betrifft eine Halbleiterkomponente und ein Verfahren zum Herstellen desselben. Offenbart wird ein Schaltungsdiagramm einer Schaltungsanordnung mit einem integrierten IGBT Halbleitertransistorschaltung mit einer weiteren exemplarischen Ausführungsform einer Treiber- und Auswerteeinheit zum Betreiben des Halbleitertransistor und zum Auswerten des temperaturabhängigen Widerstands einer Komponente.
GB 2549934 A betrifft eine Temperatur und Stromüberwachung eines IGBT und einer Freilaufdiode.
EP 1830405 A1 betrifft eine Halbleitervorrichtung, die in der Lage ist eine Temperatur eines Halbleiterchips akkurat zu überwachen.
JP 2001085629 A offenbart eine Halbleitervorrichtung mit einem Temperatursensor, welcher ein Temperatursignal mit hoher Geschwindigkeit, hoher Genauigkeit und niedrigen Kosten auslesen kann.
US 6995555 B2 betrifft eine Vorrichtung und ein Verfahren zum Bestimmen eines Stromes durch eine Halbleiterkomponente.

Zusammenfassung

Die beanspruchte Erfindung betrifft Verfahren zum Bestimmen eines Vorzeichens eines Laststroms in einer Brückenschaltung mit mindestens einer Leistungshalbleiterschaltung gemäß Anspruch 1.
Ferner wird eine verbesserte Leistungshalbleiterschaltung zur Bestimmung zumindest einer Übertemperatur beschrieben, welche die Nachteile des Stands der Technik behebt und somit zu einer platzsparenden Dimensionierung eines Leistungshalbleiters und einer reduzierten Anzahl von Anschlüssen führt. Ferner wird ein Verfahren zur Bestimmung einer Temperatur eines Leistungshalbleiterelements mittels einer Leistungshalbleiterschaltung angegeben.
Es ist darauf hinzuweisen, dass die in der nachfolgenden Beschreibung einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Es sei ferner angemerkt, dass eine hierin verwendete, zwischen zwei Merkmalen stehende und diese miteinander verknüpfende Konjunktion "und/oder" stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Eine Leistungshalbleiterschaltung zur Bestimmung einer Temperatur, insbesondere Übertemperatur, eines Leistungshalbleiterelements weist erfindungsgemäß das Leistungshalbleiterelement und einen Temperatursensor auf, wobei das Leistungshalbleiterelement eine Gateelektrode zum Ansteuern des Leistungshalbleiterelements, eine Kollektorelektrode und eine Emitterelekrode aufweist, wobei die Emitterelektrode mit einem ersten Emitteranschluss elektrisch verbunden ist und der Temperatursensor einen ersten Messpunkt mit einem Messanschluss und einen zweiten Messpunkt aufweist. Handelt es sich bei dem Temperatursensor beispielsweise um einen Temperaturwiderstand, beschreibt der erste Messpunkt ein erstes Ende und der zweite Messpunkt ein zweites Ende des Temperaturwiderstands. Handelt es sich bei dem Temperatursensor beispielsweise um eine Temperaturdiode beschreibt der erste Messpunkt die Anode und der zweite Messpunkt die Kathode der Temperaturdiode. Der zweite Messpunkt ist an die Emitterelektrode elektrisch angeschlossen, so dass zwischen dem Messanschluss und dem ersten Emitteranschluss eine über den Temperatursensor abfallende Spannung zur Temperaturmessung messbar ist.

Hierdurch wird erreicht, dass zwischen dem Messanschluss und dem ersten Emitteranschluss eine Spannung gemessen wird, welche proportional zur Umgebungstemperatur des Temperatursensors ist, wobei lediglich ein einziger zusätzlicher Anschluss, der Messanschluss, für den ersten Messpunkt benötigt wird. Ferner kann der Temperatursensor innerhalb des Leistungshalbleiterelements angeordnet sein, was zu einer Platzreduktion führt.

Vorteilhafterweise kann gemäß einer Ausgestaltung der Erfindung der Temperatursensor als Temperaturdiode mit einer Anode und einer Kathode ausgebildet sein, wobei die Kathode mit der Emitterelektrode verbunden ist. Hierdurch wird erreicht, dass im Durchlassbereich des Leistungshalbleiterelements kein Kollektorstrom des Leistungshalbleiterelements über den Temperatursensor bzw. die Temperaturdiode abfließen kann. Darüber hinaus bietet der Anschluss der Kathode der Temperaturdiode an die Emitterelektrode den Vorteil, dass sich ein die Gateelektrode des Leistungshalbleiterelements ansteuernder Gatetreiber und eine am Messanschluss angeschlossene Messelektronik zur Bestimmung wenigstens der Temperatur mittels des Temperatursensors auf ein gemeinsames Massepotential (GND) beziehen können, was die Messauswertung vereinfacht.

Vorteilhafterweise können gemäß einer weiteren Ausgestaltung der Erfindung das Leistungshalbleiterelement und der Temperatursensor in einem Modul angeordnet sein, insbesondere ist der Temperatursensor innerhalb des Leistungshalbleiterelements integriert (d. h. zum Beispiel auf demselben Die wie das Leistungshalbleiterelement angebracht) oder auf dem Leistungshalbleiterelement angeordnet. Hierdurch wird eine platzsparende Ausführung realisiert und tatsächliche Temperatur bzw. Maximaltemperatur des Leistungshalbleiterelements gemessen.

Vorteilhafterweise kann gemäß einer noch weiteren Ausgestaltung der Erfindung die Emitterelektrode über mindestens einen Bonddraht und/oder eine DCB-Leiterbahn (DCB: Direct Copper Bond) mit einem zweiten Emitteranschluss elektrisch verbunden sein, wobei der erste Emitteranschluss an den zweiten Emitteranschluss elektrisch angeschlossen ist und der mindestens eine Bonddraht und/oder eine DCB-Leiterbahn jeweils einen internen Widerstand R_bond aufweist/aufweisen, welcher als Messwiderstand R_sense zur Bestimmung eines Kollektorstroms bzw. eines Laststroms des Leistungshalbleiterelements verwendet wird. Es ist zu verstehen, dass sich der wirksame gesamte Messwiderstand R_sense aus einzelnen internen Widerständen R_bond des wenigstens einen Bonddrahts und/oder der wenigstens einen DCB-Leiterbahn zusammensetzen kann.

Hierdurch wird ermöglicht, dass auch ein über das Leistungshalbleiterelement gesteuerter Kollektorstrom bzw. Laststrom ermittelt werden kann. Hierdurch wird erreicht, dass für die Temperaturmessung und die Strommessung lediglich eine einzige Spannungsmessvorrichtung benötigt wird, da die hierin beschriebene erfindungsgemäße Verschaltung des Temperatursensors die Messung der Temperatur und des Kollektor- bzw. Laststroms des Leistungshalbleiterelements an nur einer einzigen Messstelle, das heißt dem Messanschluss, ermöglicht.

Als DCB-Leiterbahn kann allgemein jede Art von Leiterbahn zur Herstellung einer elektrischen Verbindung zwischen zwei miteinander elektrisch zu verbindenden elektrischen Komponenten verstanden werden, insbesondere hier auch eine Leiterbahn, welche die Emitterelektrode elektrisch an den zweiten Emitteranschluss anschließt, der sich beispielsweise auf einem Direct-Copper-Bond- bzw. DCB-Substrat befindet. Ein derartiges DCB-Substrat dient in wohl bekannter Weise einem leistungshalbleiterelementexternen elektrischen Anschluss bzw. einer leistungshalbleiterelementexternen elektrischen Verschaltung des Leistungshalbleiterelements. Andere, zu einem DCB-Substrat alternative Leiterbahn-Substrate sind selbstverständlich ebenfalls verwendbar. Da der erste Emitteranschluss gemäß der vorliegenden Ausgestaltung an den zweiten Emitteranschluss elektrisch angeschlossen ist, bedeutet dies, dass der interne Widerstand des wenigstens einen Bonddrahts und/oder der wenigstens einen Leiterbahn zwischen dem Messanschluss (erster Messpunkt des Temperatursensors) und dem ersten Emitteranschluss elektrisch wirksam ist.

Vorteilhafterweise kann gemäß einer weiteren Ausgestaltung der Erfindung an den Messanschluss eine Konstantstromquelle und zwischen dem Messanschluss und dem ersten Emitteranschluss ein Spannungsmessgerät angeschlossen sein. Im Fall der als Temperatursensor verwendbaren Temperaturdiode ist die Konstantstromquelle also zwischen der Anode der Temperaturdiode und dem ersten Emitteranschluss angeschlossen. Somit ist in einem Sperrzustand des Leistungshalbleiterelements eine temperaturabhängige Spannung und in einem Leitzustand des Leistungshalbleiterelements eine laststromabhängige Spannung messbar.

Gemäss der Erfindung ist die Kollektorelektrode mit einer Freilaufkathode einer Freilaufdiode und die Emitterelektrode mit einer Freilaufanode der Freilaufdiode elektrisch verbunden. Dies verhindert, dass beim Schalten vom Leitzustand in den Sperrzustand des Leistungshalbleiterelements eine eventuell angeschlossene induktive Last eine hohe Spannung am Leistungshalbleiterelement erzeugt und diese somit beschädigen könnte. Darüber hinaus ist bei Vorhandensein der zum Leistungshalbleiterelement parallel geschalteten Freilaufdiode neben der bereits erwähnten Temperatur- und Laststrommessung des Leistungshalbleiterelements an lediglich einer einzigen Messstelle (d. h. dem Messanschluss) durch die hierin beschriebene erfindungsgemäße Verschaltung des Temperatursensors zusätzlich auch noch die Fluss- bzw. Stromrichtung des Laststroms durch das Leistungshalbleiterelement mittels der am Messanschluss angeschlossene Messelektronik detektierbar. Befindet sich das Leistungshalbleiterelement nämlich in Freilauf, das heißt es findet ein Stromfluss des Kollektor- bzw. Laststroms durch die Freilaufdiode in ihrer Durchlassrichtung statt, so ist keine Änderung des laststrominduzierten Spannungsabfalls über dem Messwiderstand R_sense zwischen dem Leitzustand und dem Sperrzustand des Leistungshalbleiterelements detektierbar. Mit anderen Worten lässt sich aus dem unveränderten Spannungsabfall am Messwiederstand R_sense im Sperr- sowie im Leitzustand des Leistungshalbleiterelements folgern, dass der Laststrom in Durchlassrichtung der Freilaufdiode fließt, woraus sich die augenblickliche Stromrichtung des Laststroms unmittelbar ergibt.

Vorteilhafterweise kann gemäß einer weiteren Ausgestaltung der Erfindung die Freilaufdiode parallel mittels DCB-Leiterbahnen und/oder Bonddrähten mit dem Leistungshalbleiterelement elektrisch verbunden sein. Somit werden keine Bonddrähte benötigt, welche einen internen Widerstand aufweisen, welcher die Messung beeinträchtigt.

Vorteilhafterweise kann gemäß einer weiteren Ausgestaltung der Erfindung das Leistungshalbleiterelement ein normalleitender IGBT mit n-Kanal oder ein MOSFET-Transistor, insbesondere ein SIC-MOSFET-Transistor, sein.

Gemäß einem weiteren Aspekt der vorliegenden Erfindung wird eine Brückenschaltung angegeben, die mindestens eine Leistungshalbleiterschaltung nach einer der vorbeschriebenen erfindungsgemäßen Ausgestaltungen aufweist. Diese ermöglicht es ebenfalls, die Flussrichtung eines von einem Leistungshalbleiterelement der vorbeschriebenen Leistungshalbleiterschaltung gesteuerten Laststroms zu ermitteln. Als Brückenschaltung im Sinne dieser Erfindung ist allgemein eine wohl bekannte elektrische Schaltung, die auch als H-Schaltung, H-Brücke oder Vollbrücke bekannt ist, zu verstehen.

Gemäß einem noch weiteren Aspekt der vorliegenden Erfindung wird ein Verfahren zur Bestimmung einer Temperatur, insbesondere Übertemperatur, eines Leistungshalbleiterelements mittels einer Leistungshalbleiterschaltung nach einer der vorbeschriebenen Ausgestaltungen bereitgestellt. Das Verfahren weist wenigstens die folgenden Schritte auf:

> a) Leistungshalbleiterelement in den Sperrzustand steuern,
> b) Messen einer Spannung V_f zwischen Messanschluss und
> erstem Emitteranschluss als Temperaturspannung V_T,
> c) Ermitteln der Temperatur T als Funktion der Temperaturspannung V_T.

Hierdurch wird erreicht, dass die Temperatur des Leistungshalbleiterelements über lediglich einen einzigen zusätzlichen Anschluss, den Messanschluss, ermittelt werden kann.

Vorteilhafterweise kann gemäß einer Ausgestaltung der Erfindung zusätzlich ein Strom mittels der folgenden Schritte ermittelt werden:

> d) Ermitteln des Messwiderstands R_sense zwischen Emitterelektrode und zweitem Emitteranschluss, an den der erste Emitteranschluss elektrisch angeschlossen ist,
> e) Speichern der zuvor im Sperrzustand des Leistungshalbleiterelements gemessenen Spannung V_f als gespeicherte Temperaturspannung V_T = V_f,
> f) Steuern des Leistungshalbleiterelements in den Leitzustand,
> g) Messen der Spannung V_f zwischen Messanschluss und erstem Emitteranschluss,
> h) Ermitteln des Kollektorstroms i_c als Funktion der im Leitzustand des Leistungshalbleiterelements (20) gemessenen Spannung V_f und der gespeicherten Temperaturspannung V_T.

Hierdurch wird erreicht, dass über lediglich eine einzige Spannungsmessvorrichtung sowohl die Temperatur als auch der Strom ermittelt werden können. Der Messwiderstand R_sense ist durch einen internen Widerstand wenigstens eines Bonddrahtes und/oder wenigstens einer DCB-Leiterbahn gebildet, welcher im Folgenden mit R_bond beschrieben wird. Hierbei soll R_bond jedoch nicht dahingehend interpretiert werden, dass nur ein Bonddraht bzw. eine Leiterbahn zwingend zwischen Emitterelektrode und zweitem Emitteranschluss vorgesehen ist. Entsprechend addieren sich mehrere zwischen der Emitterelektrode und dem zweiten Emitteranschluss wirksame interne Widerstände R_bond zu einem gesamten, wirksamen Messwiderstand R_sense.

Vorteilhafterweise kann gemäß einer weiteren Ausgestaltung der Erfindung der Kollektorstrom i_c mittels der Gleichung i_c = (V_f - V_T)/R_sense bestimmt werden. Hierdurch wird analytisch eine Näherung eines Quellstroms ermittelt. Ist kein zusätzlicher Widerstand zwischen Emitterelektrode und Emitteranschluss vorgesehen, ist R_sense = R_bond.

Vorteilhafterweise kann gemäß einer noch weiteren Ausgestaltung der Erfindung die Temperatur mit einem Temperaturschwellwert verglichen werden. Hierdurch kann bei Überschreiten des Temperaturschwellwerts eine Übertemperatur detektiert werden.

Vorteilhafterweise kann gemäß einer weiteren Ausgestaltung der Erfindung der Strom i_c mit einem Stromschwellwert verglichen werden. Hierdurch kann bei Überschreiten des Stromschwellwerts ein Überstrom detektiert werden.

Gemäss der Erfindung wird in einer Brückenschaltung, welche mindestens eine erfindungsgemäße Leistungshalbleiterschaltung und eine Freilaufdiode aufweist, die Flussrichtung eines Laststroms i_L ermittelt, indem eine Spannung V_fs zwischen Messanschluss und erstem Emitteranschluss im Sperrzustand des Leistungshalbleiterelements und eine Spannung V_fl zwischen Messanschluss und erstem Emitteranschluss im Leitzustand des Leistungshalbleiterelements ermittelt werden, die Differenz V_d = V_fl - V_fs gebildet wird und, falls V_d > 0, bestimmt wird, dass der Laststrom i_L das gleiche Vorzeichen wie der Kollektorstrom i_c aufweist und andernfalls (z. B. V_d = 0) das entgegengesetzte Vorzeichen des Kollektorstroms i_c aufweist.

Wie bereits vorstehend zur erfindungsgemäßen Leistungshalbleiterschaltung ausgeführt wurde, ist eine Brückenschaltung zur Bestimmung der Stromrichtung des Laststroms i_c nicht zwingend erforderlich, sondern kann auf die im vorstehenden Absatz beschriebene Weise bereits alleine bei Vorhandensein einer zum Leistungshalbleiterbauteil der erfindungsgemäßen Leistungshalbleiterschaltung parallel geschalteten Freilaufdiode bestimmt werden.

Dies hat den Vorteil, dass die Flussrichtung eines Laststroms zusätzlich zur Temperatur- und Lastrommessung ohne zusätzliche Messvorrichtungen ermittelt werden kann.

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert wird, In dieser Zeichnung zeigen schematisch:

Fig. 1 ein Schaltbild eines TCS-IGBTs mit Messwiderstand nach dem Stand der Technik,

Fig. 2 ein Schaltbild eines Ausführungsbeispiels einer Leistungshalbleiterschaltung gemäß der Erfindung,

Fig. 3 ein Ablaufdiagramm eines Ausführungsbeispiels eines Verfahrens gemäß der Erfindung,

Fig. 4 ein Schaltbild eines weiteren Ausführungsbeispiels einer Leistungshalbleiterschaltung mit einem Leistungshalbleiterelement mit Freilaufdiode gemäß der Erfindung,

Fig. 5 ein Schaltbild eines noch weiteren Ausführungsbeispiels einer Leistungshalbleiterschaltung mit einem Leistungshalbleiterelement mit Freilaufdiode gemäß der Erfindung,

Fig. 6 beispielhafte Spannungsverläufe einer erfindungsgemäßen Leistungshalbleiterschaltung und

Fig. 7 eine Gegenüberstellung von idealer (7A) und nichtidealer (7B) elektrischer Verbindung eines Leistungshalbleiterelements und einer Freilaufdiode.

Ausführungsbeispiel

Im Folgenden wird zur Vereinfachung davon ausgegangen, dass das Leistungshalbleiterelement ein IGBT ist. Selbstverständlich sind auch alle anderen Leistungshalbleiterschalter wie zum Beispiel MOSFET Transistoren, Feldeffekttransistoren, Bipolartransistoren und Thyristoren in gleicher Weise zu betrachten. Dabei werden zur allgemeinen Beschreibung der Erfindung die Begriffe des IGBT Gateelektrode, Kollektorelektrode und Emitterelektrode verwendet.

In den unterschiedlichen Figuren sind hinsichtlich ihrer Funktion gleichwertige Teile stets mit denselben Bezugszeichen versehen, so dass diese in der Regel auch nur einmal beschrieben werden.

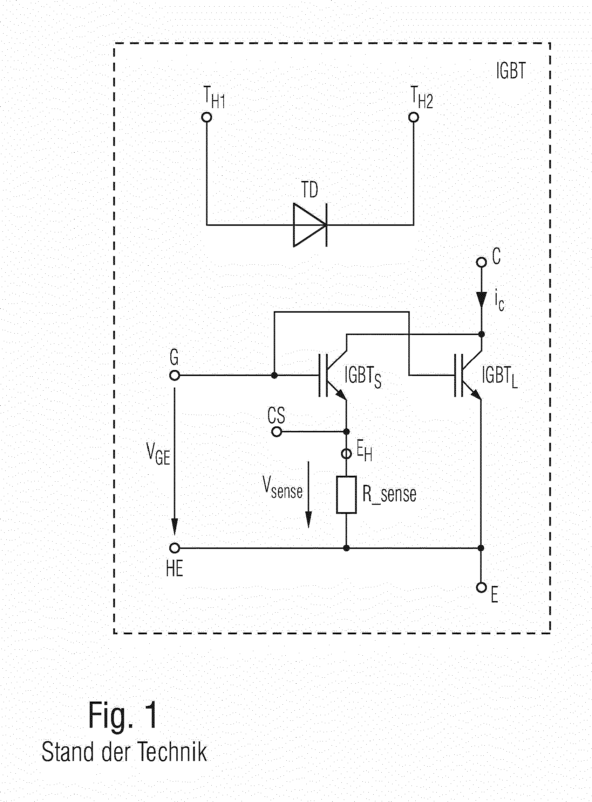

Fig. 1 zeigt einen TCS-IGBT nach dem Stand der Technik. Ein Teil der Zellen des IGBT wird für die Strommessung verwendet (IGBT$_S$). Die restlichen Zellen werden als eigentlicher IGBT verwendet, welcher zur Steuerung einer Last verwendbar ist (IGBT$_L$). Der IGBT weist eine Emitterelektrode E und eine Hilfsemitterelektrode HE auf. An die Emitterelektrode E kann die zu steuernde Last angeschossen werden. Die Hilfsemitterelektrode HE dient zur Messung des Stromflusses. Hierbei stellt HE den Masse- bzw. GND-Bezugspunkt eines eine Gateelektrode G steuernden Gatetreibers (nicht dargestellt) und eines Messwiderstands R_sense dar. Der Messwiderstand R_sense wird hierzu zwischen die Hilfsemitterelektrode HE und einer Emitterelektrode EH des IGBTs angeschlossen, an welchem ein Spannungsabfall V_sense messbar ist. Dieser Spannungsabfall ist proportional zum Strom i_sense, welcher durch den Teil der Zellen des IGBT fließt, die für die Strommessung bestimmt sind. Dieser Strom ist wiederum proportional zum Kollektorstrom i_c, welcher zwischen Kollektor C und Emitter E des TCS-IGBT fließt. Ferner weist der TCS-IGBT eine zu dem IGBT galvanisch getrennte Temperaturdiode TD auf. Über Anschlüsse TH1 und TH2 der Temperaturdiode TD ist nach Anschluss zum Beispiel einer Stromquelle ein Spannungsabfall über die Temperaturdiode TD messbar, welcher proportional zur Umgebungstemperatur der Temperaturdiode TD und somit auch proportional zur Umgebungstemperatur des IGBT ist. Ein auf einem Substrat (Platine) angeordneter TCS-IGBT nach dem Stand der Technik weist somit mindestens die folgenden sieben Anschlüsse auf:

- einen Gateanschluss G zum Anschluss eines Steuersignals und eines Gatetreibers,
- einen Emitteranschluss E zum Anschluss einer Last,
- einen Hilfsemitteranschluss HE zum Anschluss eines Messwiderstands R_sense und des Gatetreibers,
- einen Kollektoranschluss C zum Anschluss einer Versorgungsspannung,
- einen Stromsensoranschluss zum Anschluss des Messwiderstands R_sense und zur Messung des über diesen fließenden Stroms und
- zwei Anschlüsse TH1 und TH2 zum Messen der Betriebstemperatur T.

Zum Betrieb eines TCS-IGBT sind mindestens zwei Spannungsmessvorrichtungen notwendig, damit sowohl die Temperatur T als auch der Kollektorstrom i-c ermittelt werden können.

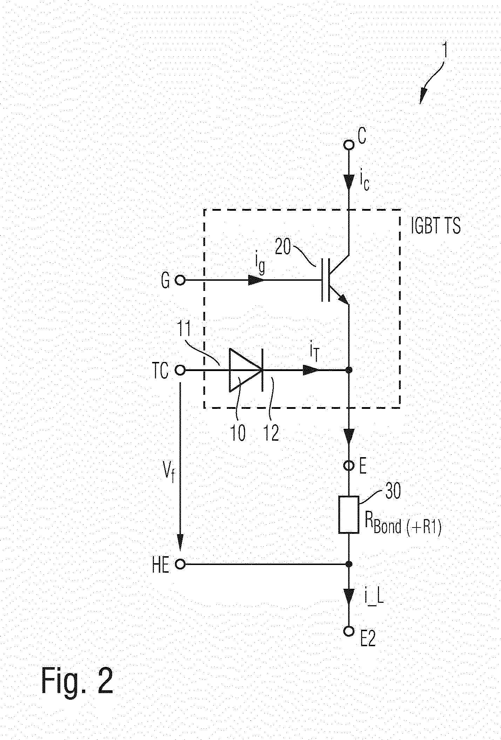

Fig. 2 zeigt ein Ausführungsbeispiel einer Leistungshalbleiterschaltung 1 gemäß der Erfindung. Hierbei wird zur Bestimmung der Temperatur eine Temperaturdiode 10 verwendet. Die Kathode 12 der Temperaturdiode ist hierzu mit der Emitterelektrode E des als IGBT ausgeführten Leistungshalbleiterelements 20 verbunden. Vorteilhaft ist es, wenn die Temperaturdiode 10 in das Modul des IGBT 20, beziehungsweise direkt in den IGBT 20, integriert ist. Alternativ ist es aber auch möglich, die Temperaturdiode 10 als externe Komponente an den ersten Emitteranschluss HE eines Standard IGBT-Moduls anzuschließen.

Im vorliegenden Ausführungsbeispiel ist die Temperaturdiode 10 in den IGBT 20 integriert, was durch die gestrichelte Umrahmung des IGBT 20 verdeutlicht sein soll. Der IGBT-Chip dieses Ausführungsbeispiels wird im Folgenden mit IGBT-TS bezeichnet und weist mindestens die folgenden Elektroden auf: eine Gateelektrode G zum Steuern des Gates des IGBT 20, eine Kollektorelektrode C, eine Emitterelektrode E. Ferner weist der IGBT-TS eine Temperaturdiode 10 auf, welche einen ersten Messpunkt - die Anode 11 - und einen zweiten Messpunkt - die Kathode 12 - aufweist. Die Anode 11 weist einen Messanschluss TC auf, an welchem eine Stromquelle als auch eine Spannungsmessvorrichtung angeschlossen werden können.

Der Messanschluss TC ist mit der Anode 11 der Temperaturdiode 10 verbunden. Hierdurch kann die Temperaturdiode 10 mit einem konstanten Strom i_T versorgt werden. Da die Kathode 12 der Temperaturdiode 10 an die Emitterelektrode E des IGBT-TS elektrisch angeschlossen ist, fließt bei Anschluss einer Stromquelle an den Messanschluss TC ein Strom durch die Temperaturdiode 10 zu dem ersten Emitteranschluss HE des IGBT-TS. Über eine Spannungsmessung zwischen dem ersten Messanschluss TC und dem ersten Emitteranschluss HE kann dann die Umgebungstemperatur T der Temperaturdiode 10 ermittelt werden, das heißt im vorliegenden Fall unmittelbar die Chiptemperatur des IGBT 20. Hierzu ist es notwendig, dass sich der IGBT-TS in seinem Sperrzustand befindet, da dann kein Kollektorstrom i_c fließt, welcher sich an der Emitterelektrode E mit dem konstanten Strom i_T überlagern würde. Der kollektorstrominduzierte (i_c) Spannungsabfall an einem internen Widerstand R_bond wenigstens eines Bonddrahts und/oder wenigstens einer (DCB-)Leiterbahn infolge des Anschlusses der Emitterelektrode E an einen zweiten Emitteranschluss E2 würde sich in einem solchen Fall zum durch den Konstantstrom i_T hervorgerufenen Spannungsabfall an R_bond addieren.

Über eine Spannungsmessung zwischen dem ersten Messanschluss TC und dem ersten Emitteranschluss HE im Sperrzustand des IGBT-TS ist der Spannungsabfall V_f an der Temperaturdiode 10 ermittelbar, aus welchem dann auf die Temperatur T des IGBT 20 geschlossen werden kann. Da die Hauptaufgabe des IGBT-TS das Schalten einer Last ist, weist der IGBT-TS einen ersten Emitteranschluss HE zum Anschluss der Spannungsmessvorrichtung und den zweiten Emitteranschluss E2 zum Anschluss der Last auf. Dies ist unproblematisch, da eine an dem ersten Emitteranschluss HE angeschlossene Spannungsmessvorrichtung (nicht dargestellt) hochohmig bzw. galvanisch getrennt ist und somit über den ersten Emitteranschluss HE nahezu kein Strom fließt. Der erste Emitteranschluss HE beeinflusst eine an dem zweiten Emitteranschluss E2 angeschlossene Last somit nicht.

Bei dem in Fig. 2 dargestellten Ausführungsbeispiel der Leistungshalbleiterschaltung 1 stellt der zweite Emitteranschluss E2 einen Anschluss- bzw. Verbindungsknoten der Emitterelektrode E auf einem externen Leiterbahn-Substrat, zum Beispiel DCB-Substrat, für den externen elektrischen Anschluss bzw. die externe elektrische Verschaltung des IGBT-TS dar. Wie Fig. 2 weiter zu entnehmen ist, ist die Emitterelektrode E hierfür beispielsweise über einen oder mehrere Bonddrähte und/oder über eine oder mehrere DCB-Leiterbahnen mit dem zweiten Emitteranschluss E2 elektrisch verbunden, wobei der wenigstens eine Bonddraht und/oder die wenigstens eine DCB-Leiterbahn einen internen Widerstand R_bond aufweist bzw. aufweisen, wie er in Fig. 2 durch einen Widerstand 30 verdeutlicht ist.

Fig. 2 ist weiterhin zu entnehmen, dass der erste Emitteranschluss HE elektrisch (z. B. unmittelbar) an den zweiten Emitteranschluss E2 angeschlossen ist. Mit anderen Worten ist der interne Widerstand 30 damit zwischen dem Messanschluss TC und dem ersten Emitteranschluss HE elektrisch wirksam und somit bezüglich TC und HE in Reihe mit der Temperaturdiode 10 geschaltet.

Aus der gemessenen Spannung V_f wird anhand einer Kennlinie eine Temperatur T des IGBT 20 ermittelt und mit einem Schwellwert T_th verglichen. Sollte die ermittelte Temperatur T oberhalb des Schwellwerts T_th liegen, wird auf eine Übertemperatur geschlossen und es werden Vorsichtsmaßnahmen zum Schutz des IGBT-TS durchgeführt. Diese können vom Drosseln des Laststroms bis zum vollständigen Abschalten der Last reichen.

Wird der IGBT-TS in seinen Leitzustand geschaltet, kann zusätzlich an dem ersten Emitteranschluss HE der Kollektorstrom i_c ermittelt werden, welcher zwischen Kollektorelektrode C und Emitterelektrode E fließt. Der Kollektorstrom i_c wird dazu als Spannungsabfall an R_bond gemessen. Vernachlässigt man den Strom, welcher über den ersten Emitteranschluss HE zur Spannungsmessvorrichtung (nicht dargestellt) fließt, fließt zwischen der Emitterelektrode E und dem zweiten Emitteranschluss E2 des IGBT 20 der Laststrom i_L, welcher sich aus der Summe von Kollektorstrom i_c und Temperaturdiodenstrom i_T zusammensetzt. Da der Kollektorstrom i_c ein Vielfaches höher als der Gatestrom i_g und der Temperaturdiodenstrom i_T ist, sind die beiden letzteren vernachlässigbar und der Laststrom entspricht somit nahezu dem Kollektorstrom: i_L ≈ i_c. Da der Gatestrom i_g lediglich zum Zeitpunkt des Ein- und Ausschaltvorgangs des IGBT 20 fließt und im vorliegenden Fall zu diesen Zeitpunkten keine Messung am Messanschluss TC vorgesehen ist, ist der Gatestrom i_g hier sogar völlig irrelevant. Der Laststrom i_L bzw. der Kollektorstrom i_c fließen zwischen der Elektrode E und dem zweiten Emitteranschluss E2 durch den Widerstand R_bond bzw. 30, so dass der hierdurch an diesem verursachte Spannungsabfall an den Anschlüssen TC und HE gemessen und der Kollektorstrom i_c auf diese Weise ermittelt werden kann.

Die Emitterelektrode E und der zweite Emitteranschluss E2 sind über wenigstens einen Bonddraht und/oder wenigstens eine DCB-Leiterbahn miteinander verbunden, welche/r einen internen elektrischen Widerstand R_bond aufweist/aufweisen. Wird der Widerstand R_bond des Bonddrahtes und/oder der DCB-Leiterbahn im Vorfeld ermittelt und ist kein zusätzlicher, vorherbestimmbarer Messwiderstand R1 zwischen die Emitterelektrode E und den zweiten Emitteranschluss E2 gesetzt, wird der interne elektrische Widerstand R_bond bzw. 30 als ein Messwiderstand für den Stromfluss verwendet: R_sense = R_bond.

Es kann jedoch auch ein zusätzlicher vorherbestimmbarer Messwiderstand R1 zwischen die Emitterelektrode E und den zweiten Emitteranschluss E2 gesetzt werden, so dass sich der Messwiderstand für den Stromfluss zwischen der Emitterelektrode E und dem zweiten Emitteranschluss E2 zu R_sense = R_bond + R1 ergibt. Eine solch mögliche Ausgestaltung der Leistungshalbleiterschaltung 1 ist in Fig. 2 durch das in Klammern gesetzte Bezugszeichen R1 angedeutet.

Besonders bevorzugt wird in diesem Fall R1 sehr viel höher als R_bond gewählt: R1 >> R_bond, weshalb dann näherungsweise R_sense = R1 gilt. Ein vorheriges Ausmessen des internen Widerstands R_bond des Bonddrahtes bzw. der Leiterbahn ist dann nicht mehr nötig. Zu einer genaueren Messung des Stromflusses zwischen der Emitterelektrode E und dem zweiten Emitteranschluss E2 kann es aber auch vorteilhaft sein, die Summe des internen Widerstands R_bond und des zusätzlichen Messwiderstands R1 zu bestimmen: R_sense = R1 + R_bond. Bei der folgenden Betrachtung wird auf den zusätzlichen Messwiderstand R1 verzichtet.

Über eine Spannungsmessung zwischen dem Messanschluss TC und dem ersten Emitteranschluss HE des IGBT 20 in seinem Leitzustand kann auf den Kollektorstrom i_c geschlossen werden. Hierzu wird in einem vorherigen Sperrzustand des IGBT 20 die temperaturabhängige Spannung V_f der Temperaturdiode 10 ermittelt und als Temperaturspannung V_T gespeichert. Anschließend wird im Leitzustand des IGBT 20 die Spannung V_f abermals gemessen und die zuvor gespeicherte Temperaturspannung V_T subtrahiert. Vernachlässigt man die Temperaturerhöhung am IGBT 20 während seines Leitzustands, ist die Differenz V_f - V_T proportional zum Laststrom i_L und somit näherungsweise zum Kollektorstrom i_c:

$$i_c \approx (V_f - V_T)/R\_sense = (V_f - V_T)/R\_bond. \quad (1)$$

Der gemessene Kollektorstrom i_c wird mit einem Stromschwellwert i_th verglichen. Sollte der gemessene Kollektorstom i_c oberhalb des Schwellwerts i_th liegen, wird auf einen Überstrom geschlossen und es werden Vorsichtsmaßnahmen zum Schutz des IGBT-TS durchgeführt. Diese können vom Drosseln des Laststroms bis zum vollständigen Abschalten der Last reichen.

Alternativ kann über die obige Gleichung auch der Laststrom i_L ermittelt werden:

$$i\_L = (V\_f - V\_T)/R\_sense = (V\_f - V\_T)/R\_bond. \quad (2)$$

Sollte also insbesondere eine angeschlossene Last vor einem zu hohen Stromfluss geschützt werden, kann dies ebenfalls über einen erfindungsgemäßen IGBT-TS erfolgen.

In Betrieb kann der IGBT-TS beispielsweise mit einem Mikrocontroller oder einer Operationsverstärkerschaltung (beides nicht dargestellt) verschaltet sein, welcher mittels eines Spannungsausgangs und gegebenenfalls eines Gatetreibers die Gateelektrode steuert. Hierzu kann es notwendig sein, eine galvanische Trennung vorzusehen. Ferner kann der Mikrocontroller die Konstantstromquelle für die Temperaturdiode 10 liefern und mittels einer Spannungsmessvorrichtung die Spannung V_f messen. Da Mikrocontroller üblicherweise lediglich Spannungsausgänge aufweisen, ist gegebenenfalls eine zusätzliche Beschaltung notwendig, welche aus einem Spannungsausgang des Mikrocontrollers eine Konstantstromquelle bildet. Bei der Verwendung von Mikrocontrollern mit reinen Digitalausgängen kann/können hierzu noch zusätzlich ein oder mehrere Digital-Analog-Wandler (DA-Wandler) vorgesehen sein. Über eine interne Regelungsstruktur des Mikrocontrollers können dann Maßnahmen in Realzeit durchgeführt werden, welche den IGBT-TS vor Überstrom und/oder Übertemperatur schützen.

Der in die Temperaturdiode 10 eingeprägte Konstant- bzw. Diodenstrom i_T muss nicht zwingend mit einem Mikrocontroller geregelt werden. Vielmehr kann hierfür auch eine geeignete Operationsverstärkerschaltung oder eine Konstantstromquelle vorgesehen sein.

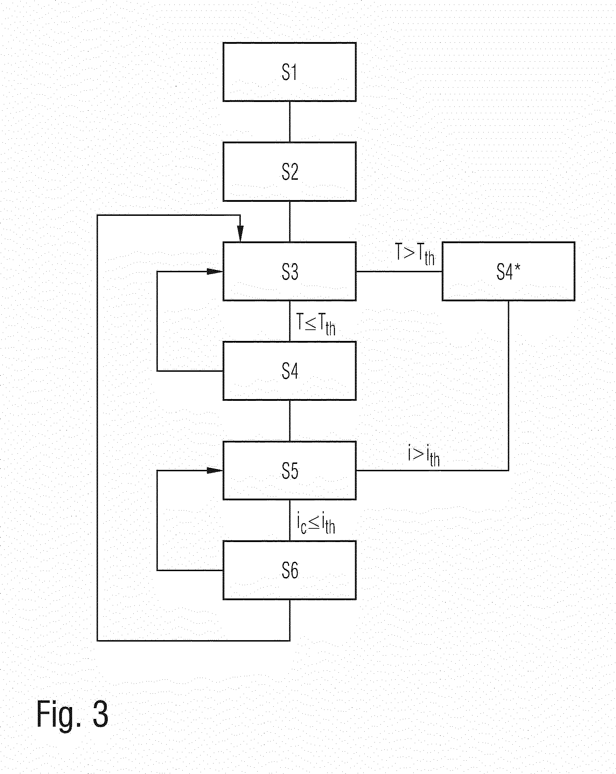

Fig. 3 stellt ein Ablaufdiagramm eines Ausführungsbeispiels eines Verfahrens gemäß der Erfindung dar.

In einem ersten Schritt S1 wird vor Inbetriebnahme des IGBT-TS der Messwiderstand R_sense zwischen der Emitterelektrode E und dem zweiten Emitteranschluss E2 bzw. dem an diesem angeschlossenen ersten Emitteranschluss HE ermittelt, welcher auf einem nichtidealen Bonddraht und/oder einer nichtidealen DCB-Leiterbahn basiert.

In einem zweiten Schritt S2 wird der IGBT-TS in Betrieb genommen und der IGBT-TS in den Sperrzustand geschaltet.

In einem dritten Schritt S3 wird die Temperatur T des IGBT 20 ermittelt und die korrespondierende, gemessene Spannung V_f in einem Speicher als Temperaturspannung V_T gespeichert. Die Temperatur T wird mit einem Schwellwert T_th verglichen. Liegt die Temperatur T unterhalb des Schwellwerts T_th, geht das Verfahren zu einem vierten Schritt S4 über. Andernfalls wird eine Schutzmaßnahme zum Schutze des IGBT-TS durchgeführt (Schritt S4*).

Solange der IGBT-TS weiterhin in seinem in Schritt S2 geschalteten Sperrzustand betrieben wird, bewirkt der Schritt S4 eine Rückkehr zu Schritt S3, andernfalls, das heißt sobald der IGBT-TS in seinen Leitzustand versetzt wird, geht das Verfahren zu einem fünften Schritt S5 über.

In dem fünften Schritt S5 wird die Spannung V_f im Leitzustand des IGBT-TS erneut gemessen und der Kollektorstrom i_c mittels der oben angegebenen Gleichung 1 berechnet. Der ermittelte Kollektorstrom i_c wird mit einem Stromschwellwert i_th verglichen. Liegt der Kollektorstrom i_c unterhalb des Schwellwerts i_th, geht das Verfahren zu einem sechsten Schritt S6 über. Andernfalls wird eine Schutzmaßnahme zum Schutze des IGBT-TS durchgeführt (siehe Schritt S4*).

Solange der IGBT-TS weiterhin in seinem ab dem Schritt S5 gesteuerten Leitzustand betrieben wird, bewirkt der Schritt S6 eine Rückkehr zu Schritt S5, andernfalls, das heißt sobald der IGBT-TS in seinen Sperrzustand versetzt wird, geht das Verfahren zu Schritt S3 zurück.

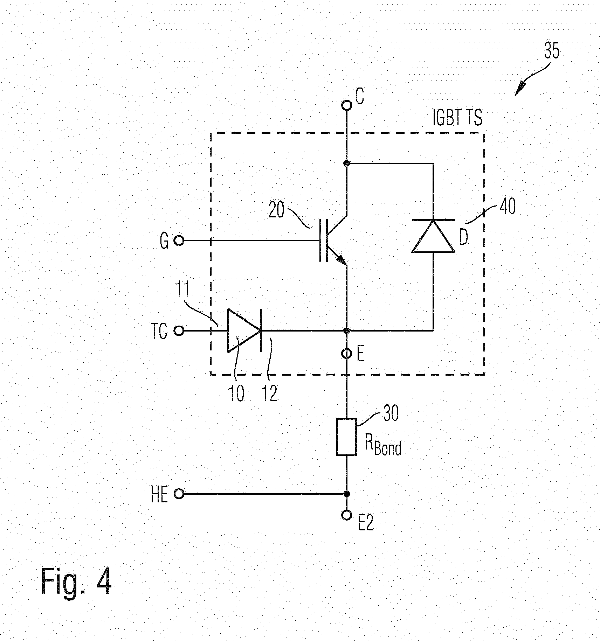

Fig. 4 zeigt ein Schaltbild eines weiteren Ausführungsbeispiels einer Leistungshalbleiterschaltung 35 mit dem Leistungshalbleiterelement 20, z. B. einem IGBT, mit Freilaufdiode 40 gemäß der Erfindung. Die Freilaufdiode 40 ist parallel zu der Kollektorelektrode C und Emitterelektrode E angeschlossen. Die Kathode der Freilaufdiode 40 (Freilaufkathode) ist an die Kollektorelektrode C angeschlossen und die Anode der Freilaufdiode (Freilaufanode) an die Emitterelektrode E des IGBT 20. Hierbei kann die Freilaufdiode 40 in den IGBT-TS integriert sein, befindet sich in einem Modul mit dem IGBT-TS oder wird als externe Komponente parallelgeschaltet. In dem in Fig. 4 dargestellten Ausführungsbeispiel ist die Freilaufdiode 40 in den IGBT-TS integriert, wie dies durch eine gestrichelte Umrandung des IGBT-TS angedeutet sein soll. Dies ist jedoch nicht zwingend erforderlich.

Die Freilaufdiode 40 verhindert u. a., dass beim Ausschalten einer an den IGBT-TS angeschlossenen induktiven Last eine hohe Spannung am IGBT-TS erzeugt wird und dieser somit gegebenenfalls beschädigt werden könnte. Die Freilaufdiode 40 sorgt dafür, dass der induzierte Strom der abgeschalteten Last über die Freilaufdiode 40 fließen kann, so dass sich ein entgegengesetzter Stromfluss des Emitterstroms zum Normalbetrieb ergibt.

Ein weiterer Vorteil der erfindungsgemäßen Leistungshalbleiterschaltung 35 ergibt sich, wenn diese inklusive einer Freilaufdiode 40 in einer Brückenschaltung, zum Beispiel einer H-Schaltung, H-Brücke oder Vollbrücke, integriert ist. Mittels der Brückenschaltung kann beispielsweise die Stromrichtung des Laststroms i_L ermittelt werden. Die Brückenschaltung ist hierzu jedoch nicht zwingend erforderlich, wie bereits vorstehend beschrieben wurde.

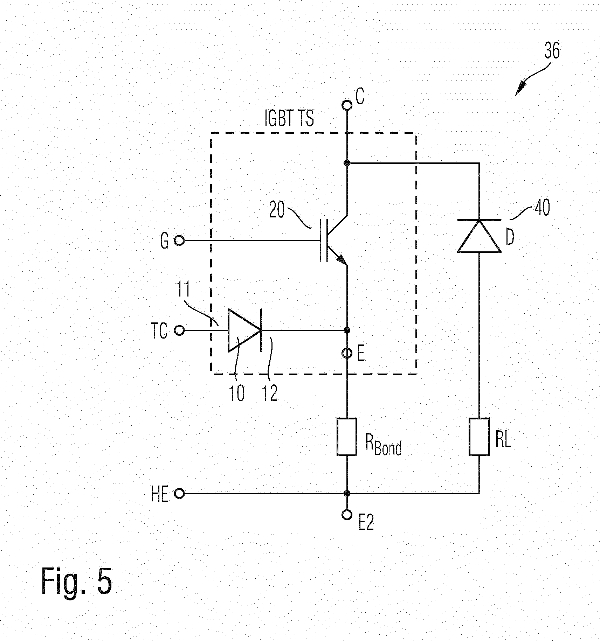

Fig. 5 stellt ein Schaltbild eines noch weiteren Ausführungsbeispiels einer Leistungshalbleiterschaltung 36 mit dem Leistungshalbleiterelement 20 (IGBT) mit einer Freifaufdiode 40 gemäß der Erfindung dar. Im Unterschied zur Leistungshalbleiterschaltung 35 der Fig. 4 ist bei der Leistungshalbleiterschaltung 36 der Fig. 5 die Freilaufdiode 40 mit ihrer Anode nicht unmittelbar an der Emitterelektrode E des IGBT 20 angeschlossen, sondern am zweiten Emitteranschluss E2, weicher zum Beispiel auf einem DCB-Substrat zur externen Verschaltung des IGBT-TS angeordnet ist. Somit ist die Freilaufdiode 40 der Leistungshalbleiterschaltung 36 auch nicht im IGBT-TS integriert, sondern extern mit diesem verschaltet, was durch die die Freilaufdiode 40 nicht umfassende gestrichelte Umrandung angedeutet sein soll. Dementsprechend ist in dem die Freilaufdiode 40 enthaltenden Schaltungszweig ein Leiterbahnwiderstand RL der die Anode der Freilaufdiode 40 mit dem zweiten Emitteranschluss E2 auf dem DCB-Substrat elektrisch verbindenden (externen) Leiterbahn wirksam.

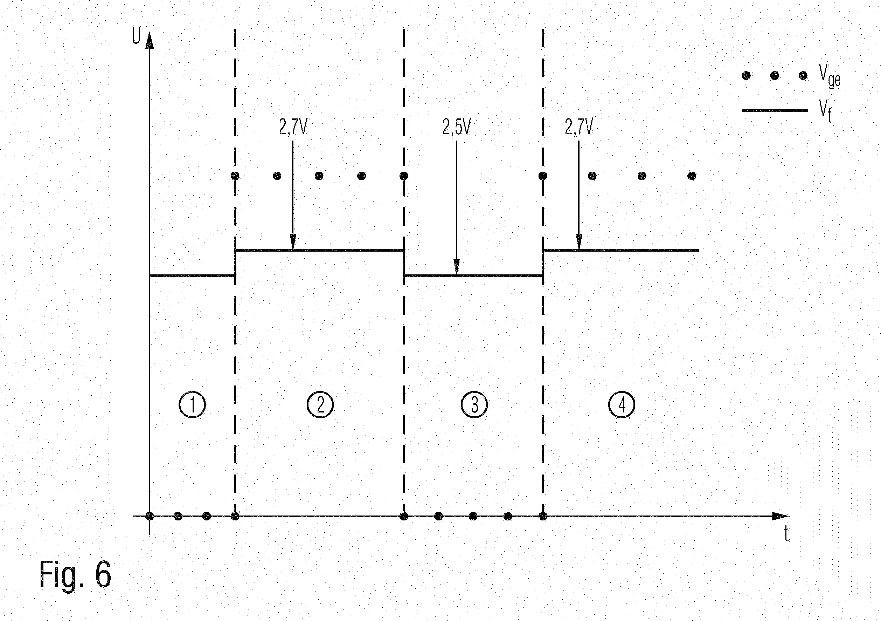

Fig. 6 zeigt beispielhafte Strom- und Spannungsverläufe der Temperaturdiode 10 einer wie zum Beispiel in Fig. 5 gezeigten erfindungsgemäßen Leistungshalbleiterschaltung 36. Befindet sich der dort gezeigte IGBT-TS im Leitzustand (d. h. es liegt eine Spannung V_ge zwischen Gateelektrode G und erstem Emitteranschluss HE bzw. zweitem Emitteranschluss E2 an und der IGBT-TS schaltet durch), ergibt sich die zwischen dem Messanschluss TC und dem ersten Emitteranschluss HE gemessene Spannung V_f als Summe der Spannungsabfälle durch die Temperaturdiode 10 und der Spannung, welche sich aus dem Produkt von Laststrom i_L und Messwiderstand R_sense ergibt. Dieser Leitzustand des IGBT-TS ist in Fig. 6 mit den Bereichen 2 und 4 gekennzeichnet. Im vorliegenden Beispiel ergibt sich dort die Summe der Spannungen zu etwa 2,7 V. Im Sperrzustand des IGBT-TS wird lediglich der Spannungsabfall an der Temperaturdiode 10 gemessen, welcher sich in diesem Fall zu etwa 2,5 V ergibt (Bereiche 1 und 3). Die Spannungsdifferenz 2,7 V - 2,5 V = 0,2 V entspricht dem Laststrom.

Befindet sich nun beispielsweise der in Fig. 5 dargestellte IGBT-TS in einer Brückenschaltung, zum Beispiel einer H-Schaltung, H-Brücke oder Vollbrücke, kann der Fall eintreten, dass der IGBT-TS im Leitzustand geschaltet ist und gleichzeitig ein Strom über die Freilaufdiode 40 fließt. In diesem Fall fließt kein Kollektorstrom i_c und somit fällt auch keine Spannung über dem Messwiderstand R_sense (hier gleich R_bond) ab. Die gemessene Spannung V_f zwischen TC und HE entspricht dann der selben Spannung wie im Sperrzustand des IGBT 20 (im vorliegenden Beispiel 2,5 V). Somit kann gefolgert werden, dass der Laststrom i_L ein entgegengesetztes Vorzeichen zum Kollektorstrom i_c aufweist.

Wie bereits an anderer Stelle hierin beschrieben wurde, lässt sich die Stromrichtung des Laststroms i_L bei einem IGBT-TS mit Freilaufdiode 40 allgemein durch einen Vergleich der zwischen TC und HE gemessenen Spannungen V_f während des Sperrzustands und des Leitzustands des IGBT 20 ermitteln. Ist keine Spannungsänderung der gemessenen Spannungen V_f zwischen dem Sperr- und dem Leitzustand detektierbar, befindet sich der IGBT-TS im Freilauf, das heißt der Laststrom fließt in Durchlassrichtung durch die Freilaufdiode 40, womit eine erste Stromrichtung eindeutig festgelegt ist. Wird jedoch eine Spannungsänderung der gemessenen Spannungen V_f zwischen dem Sperr- und dem Leitzustand des IGBT 20 gemessen, befindet sich der IGBT-TS nicht im Freilauf und die Stromrichtung des vom IGBT 20 dann geschalteten Laststroms ist der Freilaufstromrichtung entgegengesetzt. Eine wie vorstehend erwähnte Brückenschaltung ist zur Erkennung der Stromrichtung des Laststroms i_L daher nicht zwingend erforderlich.

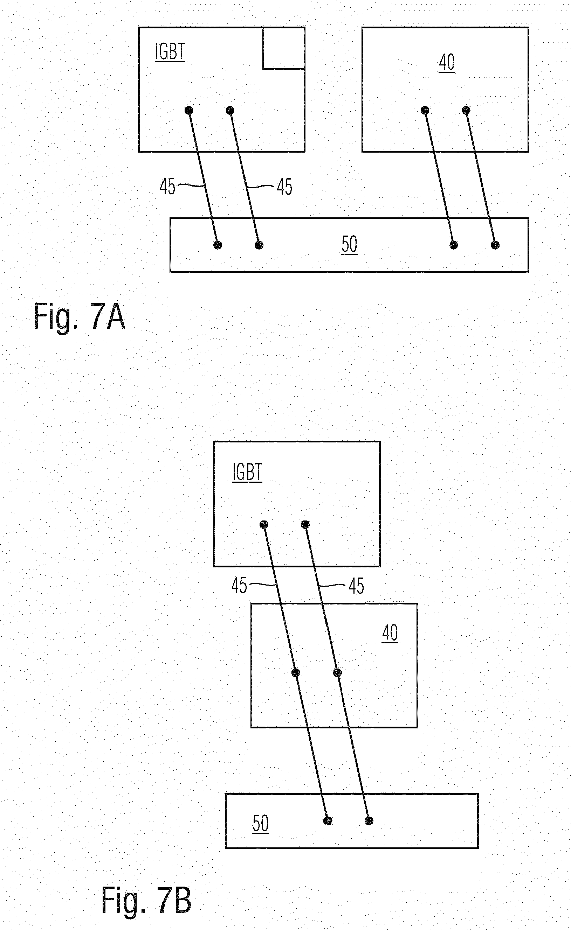

Fig. 7 zeigt in der Ansicht 7A eine hierin als ideal und in der Ansicht 7B eine hierin als nichtideal bezeichnete Verschaltung von IGBT-TS und Freilaufdiode 40. Im idealen Fall der Fig. 7A wird die Freilaufdiode 40 zum IGBT 20 parallel über Leiterbahnen 50, zum Beispiel DCB-Leiterbahnen eines den IGBT-TS extern anschließenden DCB-Substrats, deren interner Widerstand in Fig. 5 dem dort dargestellten Widerstand RL entspricht, und nicht direkt über Bonddrähte 45 angeschlossen, wie es die Fig. 7B für den nichtidealen Fall zeigt. Somit erzeugt der Freilaufstrom durch die Freilaufdiode 40 im idealen Fall der Fig. 7A keinen zusätzlichen Spannungsabfall über die Bonddrähte 45, deren interner Widerstand dem in den Fig. 2, 4 und 5 dargestellten Widerstand R_bond entspricht, und beeinflusst die Messung der Spannung V_f nicht. Somit entspricht die schematische Darstellung in Fig. 7A dem in Fig. 5 gezeigten Schaltbild der Leistungshalbleiterschaltung 36. Die Darstellung in Fig. 7B entspricht dem in Fig. 4 gezeigten Schaltbild der Leistungshalbleiterschaltung 35.

Es sei an dieser Stelle angemerkt, dass die wie in Fig. 7B gezeigte nichtideale Verschaltung durchaus bei Einsatz eines MOSFET als Leistungshalbleiterbauelement 20 aufgrund der im MOSFET selbst integrierten Bodydiode Verwendung finden kann.

Handelt es sich bei dem Leistungshalbleiterelement 20 um einen MOSFET-Transistor, gilt die gesamte vorstehende Beschreibung in entsprechender Weise. Hierbei wird darauf hingewiesen, dass die beschriebene Kollektorelektrode für MOSFET-Transistoren üblicherweise als Drainelektrode und die Emitterelektrode üblicherweise als Sourceelektrode bezeichnet werden. Entsprechend handelt es sich bei den oben beschriebenen ersten und zweiten Emitteranschlüssen demnach um erste und zweite Sourceanschlüsse.

**Patentansprüche**

1. Verfahren zum Bestimmen eines Vorzeichens eines Laststroms (i_L) in einer Brückenschaltung mit mindestens einer Leistungshalbleiterschaltung (1) zur Bestimmung einer Temperatur eines Leistungshalbleiterelements (20), die Leistungshalbleiterschaltung (1) aufweisend das Leistungshalbleiterelement (20) und einen Temperatursensor (10), wobei das Leistungshalbleiterelement (20) eine Gateelektrode (G) zum Ansteuern des Leistungshalbleiterelements (20), eine Kollektorelektrode (C) und eine Emitterelektrode (E) aufweist, wobei die Emitterelektrode (E) mit einem ersten Emitteranschluss (HE) elektrisch verbunden ist und der Temperatursensor (10) einen ersten Messpunkt (11) mit einem Messanschluss (TC) und einen zweiten Messpunkt (12) aufweist, wobei der zweite Messpunkt (12) an die Emitterelektrode (E) elektrisch angeschlossen ist, so dass zwischen Messanschluss (TC) und erstem Emitteranschluss (HE) eine über den Temperatursensor (10) abfallende Spannung zur Temperaturmessung messbar ist, und wobei die Kollektorelektrode (C) mit einer Freilaufkathode einer Freilaufdiode (40) und die Emitterelektrode (E) mit einer Freilaufanode der Freilaufdiode (40) verbunden ist, wobei eine Spannung ($V\_fs$) zwischen Messanschluss (TC) und erstem Emitteranschluss (HE) im Sperrzustand des Leistungshalbleiterelements (20) und eine Spannung ($V\_fl$) zwischen Messanschluss (TC) und erstem Emitteranschluss (HE) im Leitzustand des Leistungshalbleiterelements (20) ermittelt werden, die Differenz $V\_d = V\_fl - V\_fs$ gebildet wird und, falls $V\_d > 0$, bestimmt wird, dass der Laststrom ($i\_L$) das gleiche Vorzeichen wie der Kollektorstrom ($i\_c$) aufweist und andernfalls das entgegengesetzte Vorzeichen des Kollektorstroms ($i\_c$) aufweist.

2. Verfahren nach dem vorherigen Anspruch, **dadurch gekennzeichnet, dass** der Temperatursensor (10) als Temperaturdiode mit einer Anode als erstem Messpunkt (11) und einer Kathode als zweitem Messpunkt (12) gebildet ist, wobei die Kathode (12) mit der Emitterelektrode (E) elektrisch verbunden ist.

3. Verfahren nach einem der vorherigen Ansprüche, **dadurch gekennzeichnet, dass** das Leistungshalbleiterelement (20) und der Temperatursensor (10) in einem Modul angeordnet sind, insbesondere dass der Temperatursensor (10) innerhalb des Leistungshalbleiterelements (20) integriert oder auf dem Leistungshalbleiterelement (20) angeordnet ist.

4. Verfahren nach einem der vorherigen Ansprüche, **dadurch gekennzeichnet, dass** die Emitterelektrode (E) über mindestens einen Bonddraht und/oder mindestens eine DCB-Leiterbahn mit einem zweiten Emitteranschluss (E2) elektrisch verbunden sind, wobei der erste Emitteranschluss (HE) an den zweiten Emitteranschluss (E2) elektrisch angeschlossen ist und der mindestens eine Bonddraht und/oder mindestens eine DCB-Leiterbahn einen internen Widerstand ($R\_bond$; 30) aufweist, welcher als ein Messwiderstand ($R\_sense$) zur Bestimmung eines Laststroms ($i\_L$) des Leistungshalbeleiterelements (20) verwendet wird.

5. Verfahren nach einem der vorherigen Ansprüche, **dadurch gekennzeichnet, dass** an den Messanschluss (TC) eine Konstantstromquelle und zwischen Messanschluss (TC) und erstem Emitteranschluss (HE) ein Spannungsmessgerät angeschlossen ist und somit in einem Sperrzustand des Leistungshalbleiterelements (20) eine temperaturabhängige Spannung und in einem Leitzustand des Leistungshalbleiterelements (20) eine laststromabhängige Spannung messbar ist.

6. Verfahren nach einem der vorherigen Ansprüche, **dadurch gekennzeichnet, dass** die Freilaufdiode (40) parallel mittels DCB-Leiterbahnen und/oder Bonddrähten (50) mit dem Leistungshalbleiterelement (20) verbunden ist.

7. Verfahren nach einem der vorherigen Ansprüche, **dadurch gekennzeichnet, dass** das Leistungshalbleiterelement (20) ein normalleitender IGBT mit n-Kanal oder ein MOSFET-Transistor, insbesondere ein SIC-MOSFET-Transistor ist.

**Claims**

1. Method of determining a sign of a load current ($i\_L$) in a bridge circuit with at least one power semiconductor circuit (1) for determining a temperature of a power semiconductor element (20), the power semiconductor circuit (1) comprising the power semiconductor element (20) and a temperature sensor (10),

   wherein the power semiconductor element (20) comprises a gate electrode (G) for controlling the power semiconductor element (20), a collector electrode, (C) and an emitter electrode (E),
   wherein the emitter electrode (E) is electrically connected to a first emitter terminal (HE) and the temperature sensor (10) comprises a first measuring point (11) with a measuring terminal (TC) and a second measuring point (12), wherein the second measuring point (12) is electrically coupled to the emitter electrode (E), such that between the measuring terminal (TC) and the first emitter terminal (HE) a voltage which is dropping across the temperature sensor (10) for temperature measuring is measurable, and

wherein the collector electrode (C) is connected to a freewheeling cathode of a freewheeling diode (40) and the emitter electrode (E) is connected to a freewheeling anode of the freewheeling diode (40),

wherein a voltage (V_fs) between the measuring terminal (TC) and the first emitter terminal (HE) in a locking state of the power semiconductor element (20) and a voltage (V_fl) between the measuring terminal (TC) and the first emitter terminal (HE) in the conducting state of the power semiconductor element (20) are detected, the difference V_d = V_fl - V_fs is formed, and, if V_d > 0, it is determined that the load current (i_L) comprises the same sign as the collector current (i_c) and otherwise comprises the opposite sign of the collector current (i_c).

2. Method according to the preceding claim, **characterized in that** the temperature sensor (10) is formed as a temperature diode with an anode as first measuring point (11) and a cathode as second measuring point (12), wherein the cathode (12) is electrically connected to the emitter electrode (E).

3. Method according to one of the preceding claims, **characterized in that** the power semiconductor element (20) and the temperature sensor (10) are arranged in a module, in particular **in that** the temperature sensor (10) is integrated within the power semiconductor element (20) or arranged on top of the power semiconductor element (20).

4. Method according to one of the preceding claims, **characterized in that** the emitter electrode (E) is electrically connected via at least one bonding wire and/or at least one DCB-conductor trace to a second emitter terminal (E2), wherein the first emitter terminal (HE) is electrically connected to the second emitter terminal (E2), and the at least one bonding wire and/or at the least one DCB-conductor trace comprises an internal resistance (R_bond; 30) which is used as a measuring resistance (R_sense) for determining a load current (i_L) of the power semiconductor element (20).

5. Method according to one of the preceding claims, **characterized in that** a constant current source is coupled to the measuring terminal (TC) and a voltage measuring device is coupled between the measuring terminal (TC) and the first emitter terminal (HE) and thus in a locking state of the power semiconductor element (20) a temperature-dependent voltage and in a conducting state of the power semiconductor element (20) a load current-dependent voltage are measurable.

6. Method according to one of the preceding claims, **characterized in that** the freewheeling diode (40) is connected to the power semiconductor element (20) in parallel by DCB-conductor traces and/or bonding wires (50).

7. Method according to one of the preceding claims, **characterized in that** the power semiconductor element (20) is a normally conducting IGBT with an n-channel or a MOSFET-transistor, in particular a SIC-MOSFET-transistor.

## Revendications

1. Procédé pour définir un signe d'un courant de charge (i_L) dans un circuit en pont avec au moins un circuit semi-conducteur de puissance (1) pour définir une température d'un élément conducteur de puissance (20), le circuit semi-conducteur de puissance (1) présentant l'élément semi-conducteur de puissance (20) et un capteur de température (10), **caractérisé en ce que** l'élément semi-conducteur de puissance (20) présente une électrode de grille (G) pour piloter l'élément semi-conducteur de puissance (20), une électrode de collecteur (C) et une électrode d'émetteur (E), dans lequel l'électrode d'émetteur (E) est reliée de manière électrique à un premier raccord d'émetteur (HE) et le capteur de température (10) présente un premier point de mesure (11) avec un raccord de mesure (TC) et un deuxième point de mesure (12), dans lequel le deuxième point de mesure (12) est raccordé de manière électrique à l'électrode d'émetteur (E) de sorte qu'une tension chutant sur le capteur de température (10) peut être mesurée entre le raccord de mesure (TC) et le premier raccord d'émetteur (HE) aux fins de la mesure de température, et dans lequel l'électrode de collecteur (C) est reliée à une cathode de roue libre d'une diode de roue libre (40) et l'électrode d'émetteur (E) est reliée à une anode de roue libre de la diode de roue libre (40), dans lequel une tension (V_fs) est déterminée entre le raccord de mesure (TC) et le premier raccord d'émetteur (HE) dans l'état de blocage de l'élément semi-conducteur de puissance (20) et une tension (V_fl) est déterminée entre le raccord de mesure (TC) et le premier raccord d'émetteur (HE) dans l'état de conduction de l'élément semi-conducteur de puissance (20), la différence V_d = V_fl - V_fs est obtenue et si V_d > 0, il est défini que le courant de charge (i_L) présente le même signe que le courant de collecteur (i_c) et, dans le cas contraire, présente le signe opposé du courant de collecteur (i_c).

2. Procédé selon la revendication précédente, **caractérisé en ce que** le capteur de température (10) est formé en tant que diode de température avec une anode en tant que premier point de mesure (11) et avec une cathode en tant que deuxième point de mesure (12), dans lequel la cathode (12) est reliée de manière électrique à l'électrode d'émetteur (E).

3. Procédé selon l'une quelconque des revendications précédentes, **caractérisé en ce que** l'élément semi-conducteur de puissance (20) et le capteur de température (10) sont disposés dans un module, en particulier que le capteur de température (10) est intégré à l'intérieur de l'élément semi-conducteur de puissance (20) ou est disposé sur l'élément semi-conducteur de puissance (20).

4. Procédé selon l'une quelconque des revendications précédentes, **caractérisé en ce que** l'électrode d'émetteur (E) est reliée de manière électrique à un deuxième raccord d'émetteur (E2) par l'intermédiaire d'au moins un fil métallique de liaison et/ou d'au moins une piste conductrice DCB [Direct Copper Bond], dans lequel le premier raccord d'émetteur (HE) est raccordé de manière électrique au deuxième raccord d'émetteur (E2) et au moins un fil métallique de liaison et/ou au moins une piste conductrice DCB présentent une résistance interne (R_bond ; 30), laquelle est utilisée en tant qu'une résistance de mesure (R_sense) pour définir un courant de charge (i_L) de l'élément semi-conducteur de puissance (20).

5. Procédé selon l'une quelconque des revendications précédentes, **caractérisé en ce qu'**une source de courant constant est raccordée au raccord de mesure (TC) et un appareil de mesure de tension est raccordé entre le raccord de mesure (TC) et le premier raccord d'émetteur (HE) et ainsi une tension dépendant de la température peut être mesurée dans un état bloqué de l'élément semi-conducteur de puissance (20) et une tension dépendant du courant de charge peut être mesurée dans un état de conduction de l'élément semi-conducteur de puissance (20).

6. Procédé selon l'une quelconque des revendications précédentes, **caractérisé en ce que** la diode de roue libre (40) est reliée à l'élément semi-conducteur de puissance (20) de manière parallèle au moyen de pistes conductrices DCB et/ou de fils métalliques de liaison (50).

7. Procédé selon l'une quelconque des revendications précédentes, **caractérisé en ce que** l'élément semi-conducteur de puissance (20) est un IGBT [Insulated Gate Bipolar Transistor - transistor bipolaire à grille isolée] à conduction normale avec un canal n ou un transistor MOSFET [Metal Oxide Semiconductor Field Effect Transistor - transistor à effet de champ à grille métal-oxyde], en particulier un transistor MOSFET-SiC (transistor à effet de champ à grille métal-oxyde en carbure de silicium).

# Fig. 1
Stand der Technik

Fig. 2

Fig. 3

Fig. 4

Fig. 5

Fig. 6

EP 3 608 644 B1

Fig. 7A

Fig. 7B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120175780 A1
- GB 2549934 A
- EP 1830405 A1
- JP 2001085629 A
- US 6995555 B2